# EUROPEAN PATENT APPLICATION

(11) **EP 1 713 310 A2**
(43) Date of publication of application: **18.10.2006**
(21) Application number: 06252005.1
(22) Date of filing: 11.04.2006
(51) Int. Cl.: H05K 1/02, H05K 9/00

(54) **Printed circuit board assembly and electrical apparatus including the same**

(30) Priority: 12.04.2005 GB 0507339
(71) Applicant: Pace Micro Technology PLC, Saltaire, Shipley, BD18 3LF (GB)
(72) Inventor: Suhail, Araf, Saltaire Shipley BD18 3LF (GB)
(74) Representative: Tomkinson, Alexandra

(57) **Abstract**

A printed circuit board (PCB) is provided for use in electrical apparatus. The PCB has a plurality of layers, at least one layer being dedicated to define the PCB's external electromagnetic environment and acting as a shield and at least one further layer used for another known PCB function.

## Description

The invention to which this application relates is to the provision of an improved printed circuit board of a type which removes the need for the apparatus in which the same is provided to include a metal housing or metalised plastic housing or the like. This therefore reduces the cost of apparatus including said printed circuit board, improves the assembly of said apparatus and also allows greater flexibility in the type of housing design which can be used.

A problem which is commonly experienced in terms of assembly and also in terms of design of apparatus is that there is required to be provided a metal housing into which the components of the apparatus, such as, for example, printed circuit board connectors and the like, are required to be housed. The conventional metal housing is cuboid or square in shape and very little can be done to alter the shape of the same due to the constraints of working with metal. However, it has conventionally been regarded that the metal enclosures are necessary because of the legally binding requirements of meeting various EMC standards which typically necessitate that electrical apparatus, such as Digital Broadcast Receivers, have metal enclosures.

It is also known to provide a metallic plate which can be used under a PCB to help define the PCB's electromagnetic environment. A typical, known arrangement is shown in prior art Figures A-C. In this there is provided PCB(A), a back plate (B), and a metallic base plate (C). A series of connectors (D) are provided which serve to locate the PCB(A) in a spaced relationship in respect to the back plate and the base plate, as shown.

In known designs of the type shown in Figures A-C and which is for use with a Digital Broadcast receiver, the PCB can be a multilayer assembly with one or more layers dedicated to a ground plate also referred to as a voltage reference and current return plate. A function of the base plate is to carry currents which may otherwise flow in the wider apparatus environment. The base plate is therefore used to act as a control for the flow of the current. Typically, the distance of the base plate from any layer of the PCB is much greater than the distance between the layers of the PCB and this therefore supports the flow of the majority of functional currents through the PCB rather than the base plate.

The back plate (B), as shown in Figure A, is at one side of the PCB and housing, at the location where the cable ports are connected. In practise the back plate may be one or more sides of the housing or sections of a side.

In certain arrangements, the base plate is also required to have low impedance electrical connection along significant proportions of its interface with the back plate. Furthermore, the PCB ground plane can be connected directly or indirectly through cable connectors to the back plate along significant sections of its length which provides a low impedance shunt for currents which otherwise would have a propensity to flow into cables connected to the back plate side of the PCB, to flow back to the housing, through the base plate.

The characteristics of this type of arrangement with or without the back plate, is that they form electromagnetic resonant structures which can enhance the magnitude of electromagnetic fields at resonant frequencies (modes). However it is possible to damp specific modes by placing energy absorbing elements such as resistors, at mode centres, or in the proximity of mode centres, although it is preferred that the elements are positioned at the mode centres.

The apparatus as described has two advantageous elements in that it helps to define the PCB's electromagnetic environment using the base plate and controls the magnitude and direction of the current flow by using a combination of shunts and damping elements which are utilised and located as necessary.

While this known apparatus is functionally useful, the apparatus still requires the provision of a base plate and a metallic housing.

The aim of the present invention is to provide electrical apparatus including at least one PCB and an assembly in the apparatus which removes the need for metallic housing and/or base plate.

In a first aspect of the invention there is provided a printed circuit board (PCB) for use in electrical apparatus, said PCB having a plurality of layers, at least one layer dedicated to define the PCB's external electromagnetic environment and at least one further layer used for another known PCB function.

In one embodiment, the said layer which is dedicated to define the PCB's electromagnetic environment acts as a shield. In one embodiment the plurality of layers of the PCB are arranged in a stack and said shield layer is the bottom most layer of the PCB stack with respect to the normal orientation of the PCB within the housing of the electrical apparatus. It is the copper cladding of the PCB layer which allows it to act as a shield.

In another embodiment, the layer which is used to define the PCB's external electromagnetic environment is a top layer or furthermore, could be an inner layer of the layers of the PCB.

Thus, the at least one PCB layer acts as a shield in place of a conventional metal enclosure (i.e. the at least one PCB layer defines an enclosure, such that no metal enclosure is required).

In one embodiment, one of the further layers of the PCB is used as a ground plane for the circuits of the apparatus. In one embodiment, a functional broadcast data receiver is routed onto the said further layers of the PCB.

In one embodiment, the PCB includes four layers in total.

Preferably the PCB layers are provided in an asymmetrical arrangement (i.e. the spacing between the layers is asymmetrical). A symmetrical arrangement of PCBs can be provided but improved results are found when an asymmetrical arrangement is used.

In one embodiment, a plurality of vias are positioned along the length of an edge of the PCB. In one embodiment, the said edge is the edge of the PCB provided with a series of cable ports. The said vias are used to connect the layer dedicated to defining the PCB's external electromagnetic environment, to a ground plane.

Alternatively, a conductive component, such as for example copper tape, is provided to connect the ground plane and the PCB layer defining the electromagnetic environment.

In a preferred embodiment it is the combination of using at least one layer of the PCB as a shield, using one further layer as a ground plane, using damping elements to connect the shield layer to the ground plane either alone or in combination with one or more vias and providing the layers in an asymmetrical arrangement which is advantageous.

Preferably the damping elements can include one or more resistors.

In a further aspect of the invention there is provided electrical apparatus, said electrical apparatus including at least one PCB having a plurality of layers, at least one layer dedicated to define the PCB's external electromagnetic environment and at least one further layer used for another known PCB function.

Specific embodiments of the invention are now provided with reference to the accompanying diagrams, wherein:-
Figure 1 shows a first PCB structure in accordance with the present invention; and
Figure 2 shows a second embodiment of a PCB structure in accordance with the invention.

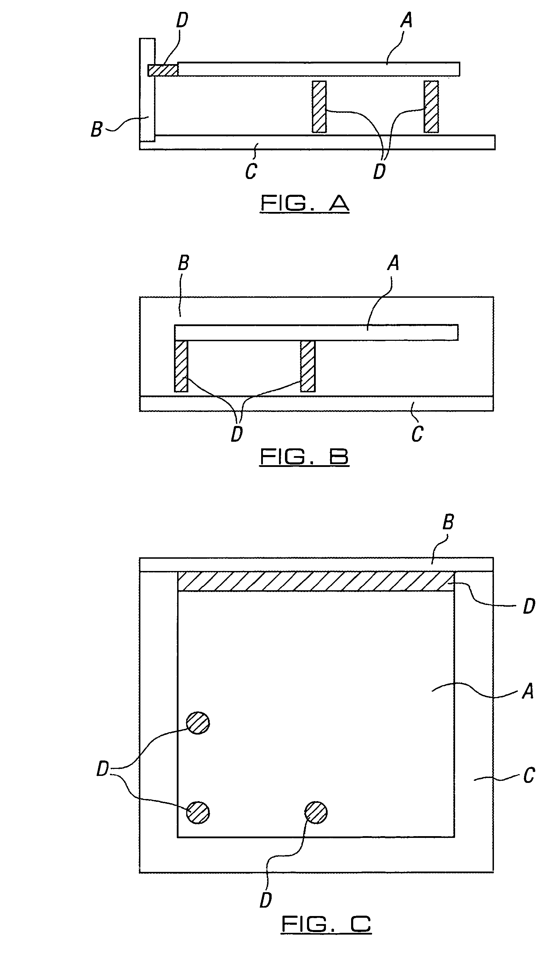

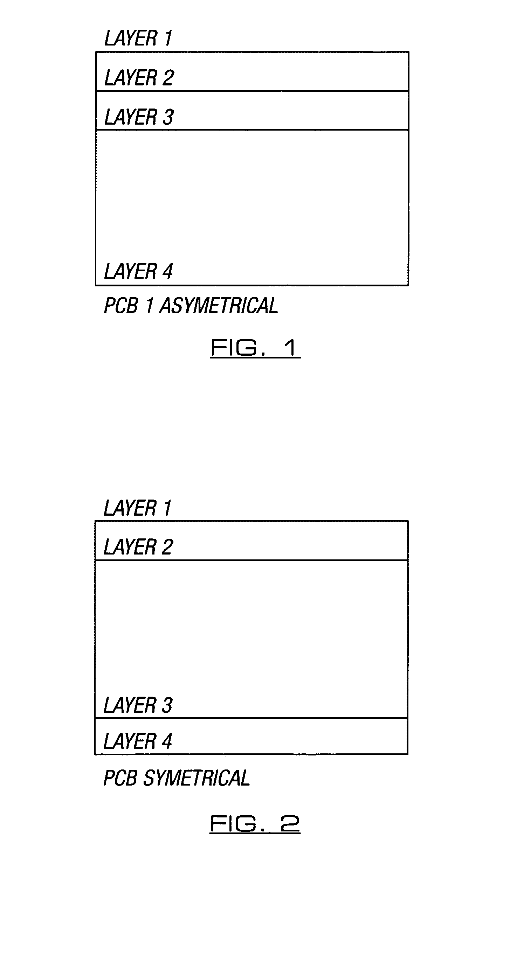

In both embodiments of Figures 1 and 2, the PCB comprises four layers, with layer 4 being the layer which is used to define the electromagnetic environment of the PCB. The further layers, layers 1, 2 and 3, can be used in a conventional manner. Typically the layer 4 is connected to a ground plane (not shown) by any or any combination of vias, or other conductive components such as copper tape. Preferably the vias are provided in a configuration to form a "via wall" such that the vias are provided in a linear configuration. The via wall may be provided at an edge of the PCB or alternatively can be located inward of the PCB itself.

The planes which define the electromagnetic environment may not be continuous and could be provided with apertures to accommodate vias for conventional purposes as used in the other layers of the PCB, and/or thermal performance, or the like.

In trials, the edges of the three further layers, 1, 2 and 3 were tested under two configurations, an open structure and a closed structure in order to determine whether the PCB would operate in a satisfactory manner.

The open structure is defined as a condition when there is no connection between the ground and shield along the said edge of the PCB, except via appropriately positioned damping elements. The closed structure is defined as the condition where the shield and ground planes are directly connected along the PCB edge through the vias or other conductive components. In this case, the damping elements were appropriately positioned inboard and connected between the shield and ground.

Although tested in accordance with an open structure and a closed structure, it should be appreciated that the apparatus could include a combination of open and closed edge structures in conjunction with appropriately positioned and connected damping elements as required.

In both test conditions, the product was tested for radiated emissions and compared with the emissions from a production version of a broadcast data receiver, within and without a metallic enclosure.

In the test results, it was identified that the PCB techniques tested were successful and in each case emission was low or lower than the radiated emissions from the normal conventional broadcast data receiver within its enclosure. Also, the results were far lower than the production broadcast data receiver outside of its enclosure and therefore the PCB emissions were found to match or exceed those apparatus which included metallic base plate and/or side plates.

Furthermore, it was found that the asymmetrical PCB as shown in Figure 1 had significantly lower emissions than its symmetrical PCB of the type shown in Figure 2 and closed edge structures with damping resulted in lower emissions than open edge structures with damping.

Thus there is provided a PCB assembly for electrical apparatus which can be designed to operate successfully outside of a metal housing. While it has been found that non-symmetrical PCB's appear to exhibit lower emissions than symmetrical PCB's, it is found that both structures would operate in a satisfactory manner without the need for a metal housing thereby freeing up the opportunity for either the metal housing to be eliminated and/or replaced with other forms of enclosure which may allow significantly improved design characteristics.

The techniques help define a PCB's electromagnetic environment through the use of a dedicated plane of the PCB and help control the direction and magnitude of currents by using shunts such as vias or other conductive components and damping elements such as resistors or other similar components.

## Claims

1. A printed circuit board (PCB) for use in electrical apparatus, said PCB having a plurality of layers, at least one layer dedicated to define the PCB's external electromagnetic environment and at least one further layer used for another known PCB function.

2. A PCB according to claim 1 wherein the at least one layer of the PCB defining the PCB's external electromagnetic environment acts as a shield.

3. A PCB according to claim 1 wherein the at least one further layer is used as a ground plane for the circuits of the apparatus.

4. A PCB according to claim 3 wherein one or more vias are used to connect the further layer used as the ground plane to the layer being used to define the PCB's external electromagnetic environment.

5. A PCB according to claim 4 wherein a plurality of vias are positioned along an edge of the PCB.

6. A PCB according to claim 5 wherein the edge of the PCB with said vias is provided with a series of cable ports.

7. A PCB according to claim 3 wherein a conductive component is used to connect the further layer used as a ground plane to the layer being used to define the PCB's external electromagnetic environment.

8. A PCB according to claim 7 wherein the conductive component is copper tape.

9. A PCB according to claims 4 or 7 wherein in addition to the one or more vias or conductive component, one or more damping elements are provided between the further layer acting as the ground plane and the layer being used to define the PCB's external electromagnetic environment.

10. A PCB according to claim 3 wherein one or more damping elements are the only connection between the further layer acting as the ground plane and the layer being used to define the PCB's external electromagnetic environment.

11. A PCB according to claims 9 or 10 wherein the damping elements are in the form of one or more resistors.

12. A PCB according to claim 1 wherein a broadcast data receiver is routed into the at least one further layer of the PCB.

13. A PCB according to claim 1 wherein the PCB includes four layers in total.

14. A PCB according to claim 1 wherein the plurality of layers are provided in an asymmetrical arrangement.

15. A PCB according to claim 1 wherein the at least one layer of the PCB defining the PCB's external electromagnetic environment acts as a shield, the at least one further layer is used as a ground plane for the circuits of the apparatus and the plurality of layers are provided in an asymmetrical arrangement.

16. A PCB according to claim 15 wherein one or more vias are used to connect the ground plane to the shield and damping elements are located inboard of said plurality of PCB layers.

17. A PCB according to claim 1 wherein the plurality of layers are arranged in a stack and the at least one layer dedicated to define the PCB's external electromagnetic environment is located at the base or top of the stack.

18. A PCB according to claim 1 wherein the plurality of layers are arranged in a stack and the at least one layer dedicated to define the PCB's external electromagnetic environment is located intermediate a base layer and a top layer of the stack.

19. Electrical apparatus, said electrical apparatus including at least one PCB having a plurality of layers, at least one layer dedicated to define the PCB's external electromagnetic environment and at least one further layer used for another known PCB function.
